(19) Europäisches Patentamt
European Patent Office
Office européen des brevets

(11) **EP 2 355 141 A2**

(12) **EUROPEAN PATENT APPLICATION**

(43) Date of publication:
**10.08.2011 Bulletin 2011/32**

(51) Int Cl.:
**H01L 21/77** *(2006.01)*

(21) Application number: **11153475.6**

(22) Date of filing: **07.02.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **08.02.2010 JP 2010025359**
**08.02.2010 JP 2010025360**
**08.02.2010 JP 2010025361**

(71) Applicant: **Fujifilm Corporation**
**Minato-ku**
**Tokyo (JP)**

(72) Inventors:
• **Sato, Keigo**
**Kanagawa-ken (JP)**
• **Yuuya, Shigenori**
**Kanagawa-ken (JP)**

(74) Representative: **Klunker . Schmitt-Nilson . Hirsch**
**Patentanwälte**
**Destouchesstrasse 68**
**80796 München (DE)**

(54) **Semiconductor device, method for producing the semiconductor device, substrate for semiconductor element and method for producing the substrate**

(57)    [Objectives]
First, a semiconductor device having favorable properties will be produced. Second, the occurrence of cracks in a porous layer formed on the substrate of a semiconductor device will be suppressed, to realize a high performance semiconductor device, even if it has a large area. Third, the adhesion properties of a porous layer formed on a resin substrate will be improved, to suppress separation of the resin substrate and the porous layer.

[Constitution]
A semiconductor device is provided with a porous structure layer (4) formed by silicone resin between a substrate (2) and a semiconductor element (3). Alternatively, a porous layer (24) having a density of $0.7 g/cm^3$ or less, formed by a compound obtained by hydrolyzing and condensing at least one type of alkoxysilane selected from a group consisting of monoalkoxysilane, dialkoxysilane, and trialkoxysilane, and tetraalkoxysilane is provided between a substrate (22) and a semiconductor element (23) of a semiconductor device (21). As a further alternative, an adhesion layer (33) formed by a compound obtained by hydrolyzing and condensing an alkoxysilane is provided on a resin substrate (32), and a porous layer (34) having a density of $0.7 g/cm^3$ or less, formed by a compound obtained by hydrolyzing and condensing an alkoxysilane, is provided on the adhesion layer (33).

# FIG.1

**Description**

BACKGROUND OF THE INVENTION

Field of the Invention

The present invention is related to a semiconductor device, such as a solar battery, a thin film transistor circuit, and a display (image display device), as well as a method for producing the semiconductor device. The present invention is also related to a substrate for a semiconductor element and a method for producing the substrate.

Description of the Related Art

Much research is being performed in order to form semiconductor devices such as displays and thin film solar batteries to be flexible. Resin films such as PET and polyimide are being employed as substrates, in order to impart flexibility to such devices. However, these substrates have lower heat resistance compared to conventional glass substrates, and therefore there is a problem that the semiconductor production processing temperature is limited to those in the vicinity of room temperatures. Meanwhile, semiconductors produced by high temperature processes generally exhibit favorable semiconductor properties. This is an obstacle to realizing semiconductor devices which are flexible and exhibit favorable semiconductor properties.

Various techniques have been proposed as methods for overcoming this obstacle. For example, Japanese Unexamined Patent Publication Nos. 11(1999)-024106 and 11(1999)-031828 disclose a method in which a semiconductor circuit is formed on a glass substrate in advance. Thereafter, the semiconductor circuit is peeled off or dissolved, and then transferred onto a resin substrate. According to this method, no restrictions due to the heat resistance properties of resin are applied during the semiconductor production step. However, additional steps such as peeling and transferring become necessary. In addition, it is extremely difficult to realize semiconductor devices having large areas with stable quality.

PCT Japanese Publication No. 2001-508937 proposes a method, in which an $SiO_2$ film and an amorphous Si film are layered on a PET film, and then the amorphous Si film is converted to a polycrystalline Si layer by irradiating an excimer laser thereon. The degree of carrier motility is far greater in crystalline Si compared to amorphous Si, and there is a possibility that a high performance semiconductor device can be produced by this method. However, $SiO_2$ films are rigid, and the coefficient of thermal expansion thereof is greatly different from that of PET. Therefore, there is a high probability that cracks and separation will occur due to heating by excimer laser irradiation. In addition, excimer lasers are expensive and unstable, which poses problems with respect to high volume production.

As described above, it is necessary to produce semiconductor devices by processes at high temperatures that exceed 200°C in order to improve the performance thereof. However, heating during conventional production methods for semiconductor devices is limited by the material of the substrate. Therefore, it is currently the case that improved performance is sought by adding production steps, or by sacrificing production costs and productivity.

Accordingly, a first objective of the present invention is to provide a semiconductor device and a production method therefor that enable high temperature processing regardless of the material of the substrate. Particularly, it is an objective of the present invention to provide a substrate structure which can be favorably utilized for a flexible semiconductor device having a large area and a production method therefor.

Porous metal compounds are known as thermal insulating materials which are provided on substrates in order to perform high temperature processes. A typical example is mesoporous silica, represented by silica aerogel and silica xerogel. Forming mesoporous silica as thin films on glass and metal substrates has been widely attempted (refer to Japanese Unexamined Patent Publication No. 2001-118841). However, when such materials are formed as films on resin substrates, problems, such as separation, decreased transmissivity due to fine pores within the porous structures becoming crushed, bleaching, and cracks being generated, occur.

Japanese Unexamined Patent Publication No. 2001-139321 discloses a method for solving the problem of silica aerogel bleaching. In this method, alkoxysilane is hydrolytically polymerized to form a gel compound as a thin film, the gel compound is immersed in a curing solution that contains a hydrolytic polymerization catalyst for the alkoxysilane to performing curing, and then the gel compound undergoes supercritical drying. According to this method, drying of the gel compound during curing and dispersion of the hydrolytic polymerization catalyst within the gel compound can be prevented. Therefore, it is considered that bleaching, shrinking, and cracks being formed in the gel compound film can be prevented. However, a high pressure apparatus is necessary to perform supercritical drying, which is unreasonable considering realistic production costs.

Japanese Unexamined Patent Publication No. 2003-267719 discloses a method that does not require supercritical drying. In this method, one or more metals or semimetals selected from a group consisting of alkoxide, organoalkoxysilane, and polyorganosiloxane and $H_xSi$ ($R^5$) y ($OR^6$) $_{4-x-y}$ ($R^5$ and $R^6$ are organic groups having carbon numbers of 1 or greater, x is an integer from 1 to 3, y is an integer from 0 to 3, and x+y≤4) are dissolved in an organic solvent, hydrolyzed or partially hydrolyzed, gelled, and dried. A porous body can be produced at low temperature and normal pressure by this process, by adjusting the amount of $H_xSi(R^5)_y(OR^6)_{4-x-y}$.

Meanwhile, U.S. Patent No. 6,410,149 teaches the use of a nanoporous silica thin film having silane as its base as a low dielectric material film for an integrated circuit.

There is a problem that cracks appear every few millimeters when nanoporous silica is formed as a film on a substrate. These cracks greatly affect the performance of semiconductor devices having large areas, such as displays and thin film solar batteries. It is thought that the cracks are caused by temporary shrinking of the film during drying of solvent. That is, the porous film shrinks to a large degree due to capillary action accompanying evaporation of the solvent. However, because the substrate and the porous film are adhered at the interface therebetween, an extremely large amount of tensile stress is applied to the porous film. The substrate and the porous film flex integrally up to a certain amount of tensile stress. However, when the applied tensile stress exceeds the breaking stress point of the porous film, cracks form in the porous film to alleviate the stress. The shrinkage due to capillary action is temporary, and the porous film is restored to a degree after drying. However, the cracks will remain.

The problem associated with these types of cracks cannot be solved by adjusting inclusion amounts as disclosed in Japanese Unexamined Patent Publication No. 2003-267719. Note that the nanoporous silica thin film disclosed in U.S. Patent No. 6, 410,199 is utilized to produce integrated circuits, and the problem of cracks being formed would not occur during production of integrated circuits in any case.

Accordingly, the second objective of the present invention is to suppress the occurrence of cracks in a porous layer formed on the substrate of a semiconductor device, to realize a high performance semiconductor device, even if it has a large area.

Japanese Unexamined Patent Publication No. 2004-168615 discloses a porous silica film capable of separating/filtering liquid substances such as water and organic solvents, having a great number of pores with an average diameter of 1nm or greater. An intermediate film is formed between the porous silica film and a substrate.

Separation that occurs when mesoporous silica is formed as a film on a resin substrate is caused by: insufficient adhesion between the substrate and the porous layer; volume shrinkage accompanying hydrolysis during sol gel reactions of metal alkoxides; and large amounts of shrinkage due to an extremely large amount of stress applied by capillary action during drying of a solvent resulting in the porous layer, which should be bound to the substrate, structurally relieving itself free of the bond. Accordingly, the problem of separation cannot be addressed by the aforementioned methods disclosed in Japanese Unexamined Patent Publication Nos. 2001-139321 and 2003-267719. Roughening the surface of the substrate may be considered as a technique to interactions between the substrate and the porous layer. However, there is a problem that transparency will deteriorate, in cases that it is necessary for the substrate to be transparent.

There are techniques in which active hydroxyl groups are formed on the surface of the substrate to improve the wettability thereof, and techniques in which an ozone treatment, a flame treatment, or the like are administered with the objective of improving the adhesive properties with respect to the porous film. With respect to the former technique for improving the wettability, in cases that porous structures are formed by phase separation using surfactants as templates, coating liquids are often water based solvents, while substrates are often hydrophobic. Therefore, it is generally considered that processes to improve the wettability of the substrate by surface processing would be effective. However, in the case that a porous layer is formed on a substrate it becomes difficult to form strong bonds between the two because the actual contact area decreases, particularly as porosity increases.

Note that the intermediate film disclosed in Japanese Unexamined Patent Publication No. 2004-168615 is formed by a ceramic, such as alumina, silica, zirconia, titania, and magnesia. The wettability of the intermediate film with respect to the substrate is favorable. The intermediate film is coupled with the substrate with great coupling strength, and problems such as separation and cracks forming do not occur even under high temperatures. However, the substrate is also ceramic, and the intermediate layer is formed by sintering. Therefore, the problem of intermediate film structurally relieving itself free of the bond with the substrate would not occur in any case.

Accordingly, the third objective of the present invention is to improve the adhesion properties of a porous layer formed on a resin substrate, to provide a substrate for a semiconductor element capable of suppressing separation of the resin substrate and the porous layer, and a method for producing the substrate. Further, the present invention will provide a semiconductor device equipped with the substrate for a semiconductor element.

SUMMARY OF THE INVENTION

A semiconductor device corresponding to the first objective (hereinafter, referred to as "first invention") comprises:

a substrate; and
a semiconductor element; and is characterized by:

a porous structure layer formed by silicone resin being provided between the substrate and the semiconductor layer.

It is preferable for the density of the porous structure layer formed by silicone resin to be 0.7g/cm$^3$ or less.

It is preferable for 95% by mass or greater of the porous structure layer formed by silicone resin to be a silicone resin constituted by one of silsesquioxane and siloxane, and 20% by mass or greater of the silicone resin to be silsesquioxane.

It is preferable for the silsesquioxane to be one of methyl silsesquioxane and phenyl silsesquioxane.

It is preferable for the substrate to be a resin substrate.

A method for producing a semiconductor device of the first invention comprises the steps of:

providing the porous structure layer formed by silicone resin on the substrate;
providing a semiconductor element layer on the porous structure layer; and
intermittently heating the device only from the side of the semiconductor element layer.

It is preferable for the heating to be performed by light or by an electron beam.

A semiconductor device corresponding to the second objective (hereinafter, referred to as "second invention"), is characterized by comprising:

a substrate;
a semiconductor element; and
a porous layer having a density of 0.7g/cm$^3$ or less, formed by a compound obtained by hydrolyzing and condensing at least one type of alkoxysilane selected from a group consisting of monoalkoxysilane, dialkoxysilane, and trialkoxysilane, and tetraalkoxysilane, provided between the substrate and the semiconductor layer.

It is preferable for the at least one type of alkoxysilane to be a trialkoxysilane. It is more preferable for the trialkoxysilane to be methyl trialkoxysilane.

Amethod for producing a substrate for a semiconductor element of the second invention is characterized by comprising:

coating a substrate with a coating solution containing at least one type of alkoxysilane selected from a group consisting of monoalkoxysilane, dialkoxysilane, and trialkoxysilane, and tetraalkoxysilane, to form a coating film; and
forming a porous layer having a density of 0.7g/cm$^3$ or less by heating that causes hydrolysis and condensation of the alkoxysilanes within the coating film.

It is preferable for the percentage by mass of tetraalkoxysilane with respect to all of the alkoxysilanes included in the coating solution to be 80% or less.

It is preferable for the coating solution to include a surfactant. In this case, the surfactant is removed after heating the alkoxysilanes within the coating film to cause the hydrolysis and the condensation reaction.

A substrate for a semiconductor element corresponding to the third objective (hereinafter, referred to as "third invention") is characterized by comprising:

a resin substrate;
an adhesion layer formed by a compound obtained by hydrolyzing and condensing an alkoxysilane provided on the substrate; and
a porous layer having a density of 0.7g/cm$^3$ or less, formed by a compound obtained by hydrolyzing and condensing an alkoxysilane, provided on the adhesion layer.

The alkoxysilane that forms the adhesion layer (the adhesion layer is not porous) and the alkoxysilane that forms the porous layer maybe the same alkoxysilane or different alkoxysilanes. Preferably, the alkoxysilane which is employed to form the adhesion layer is organo trialkoxysilane; and the alkoxysilane which is employed to form the porous layer is an alkoxysilane selected from a group consisting of tetramethoxysilane, methyltrimethoxysilane, and methyldimethoxysilane.

Amethod for producing a substrate for a semiconductor element of the third invention is characterized by comprising:

coating a resin substrate with a coating solution containing an alkoxysilane, to form a first coating film;
forming an adhesion layer by heating that causes hydrolysis and condensation of the alkoxysilane within the first coating film;
coating the adhesion layer with a coating solution containing an alkoxysilane, to form a second coating film;
forming a porous layer having a density of 0.7g/cm$^3$ or less by heating that causes hydrolysis and condensation of the alkoxysilanes within the second coating film.

It is preferable for the coating solution for forming the porous layer to include a surfactant. In this case, the surfactant is removed after heating the alkoxysilane within the second coating film to cause the hydrolysis and the condensation reaction.

It is preferable for the semiconductor device of the third invention to be a thin film transistor circuit, a solar battery, or an image display device, comprising:

a substrate for semiconductor element of the third invention; and
a semiconductor element.

The semiconductor device of the first invention is of a structure in which the porous structure layer formed by silicone resin is providedbetween the substrate and the semiconductor element. The semiconductor element is provided on the porous structure layer formed by silicon. Therefore, heating processes at high temperatures are enabled regardless of the material of the substrate. Improvements in performance of the semiconductor device are enabled, such as improvements in electron mobility in the case that the semiconductor device is a thin film transistor circuit.

The method for producing the semiconductor device of the first invention comprises the steps of: providing the porous structure layer formed by silicone resin on the substrate; providing the semiconductor element layer on the porous structure layer; and intermittently heating the device only from the side of the semiconductor element layer. Therefore, heating sufficient to improve the performance of the semiconductor element layer can be applied to the device from the side of the semiconductor element layer, prior to the heat being transferred to the substrate by the porous structure layer formed by silicone resin. Accordingly, a high performance semiconductor device can be produced at low cost, without complex steps, and with favorable productivity.

The semiconductor device of the second invention is equipped with: the substrate; the semiconductor element; and the porous layer having a density of 0.7g/cm$^3$ or less, formed by a compound obtained by hydrolyzing and condensing at least one type of alkoxysilane selected from a group consisting of monoalkoxysilane, dialkoxysilane, and trialkoxysilane, and tetraalkoxysilane, provided between the substrate and the semiconductor layer. Therefore, it is possible to prevent cracks from being generated in the porous layer provided on the substrate. Accordingly, a high performance semiconductor device can be realized, even if it has a large area.

The method for producing the substrate for a semiconductor element of the second invention comprises the steps of: coating a substrate with a coating solution containing at least one type of alkoxysilane selected from a group consisting of monoalkoxysilane, dialkoxysilane, and trialkoxysilane, and tetraalkoxysilane, to form a coating film; and forming a porous layer having a density of 0.7g/cm$^3$ or less by heating that causes hydrolysis and condensation of the alkoxysilanes within the coating film. Therefore, substrates for semiconductor elements can be produced at low cost and high productivity, without employing expensive equipment, such as a high pressure apparatus.

The substrate for a semiconductor element of the third invention, is equipped with the adhesion layer formed by a compound obtained by hydrolyzing and condensing an alkoxysilane, provided between the resin substrate and the porous layer having a density of 0.7g/cm$^3$ or less, formed by a compound obtained by hydrolyzing and condensing an alkoxysilane. Therefore, the adhesive properties of the porous layer formed on the resin substrate are improved, and separation of the resin substrate and the porous layer can be suppressed.

That is, when porous layers are formed as films on resin substrates, problems, such as separation, decreased transmissivity due to fine pores within the porous structures becoming crushed, bleaching, and cracks being generated, occur, due to the great amount of shrinking during a drying process. However, the third invention is equipped with the adhesion layer formed by a compound obtained by hydrolyzing and condensing an alkoxysilane, and therefore separation of the resin substrate and the porous layer can be suppressed. In addition, because the fine pores within the porous structure do not become crushed, problems, such as deterioration of transmissivity and bleaching can also be suppressed.

BRIEF DESCRIPTION OF THE DRAWINGS

Figure 1 is a schematic sectional view that illustrates a semiconductor device according to an embodiment of the first invention.
Figure 2 is a graph that illustrates the relationship between the density of polysilsesquioxane of a porous structure and heat transfer rates.

Figure 3 is a graph that simulates changes in heating times and surface temperatures in the case that zinc is used as a surface.

Figure 4 is a graph that simulates changes in heating times and temperature distribution during asymmetrical heating.

Figure 5 is a schematic sectional view that illustrates a semiconductor device according to an embodiment of the second invention.

Figure 6 is a schematic sectional view that illustrates a substrate for a semiconductor element of the third invention.

Figure 7 is a schematic sectional view that illustrates a semiconductor device that employs the substrate for a semiconductor element of the third invention.

Figure 8 is a sectional SEM image of Embodiment 1 of a substrate for a semiconductor element of the third invention.

Figure 9 is a sectional SEM image of Comparative Example 1 of a substrate for a semiconductor element of the third invention.

DESCRIPTION OF THE PREFERRED EMBODIMENTS

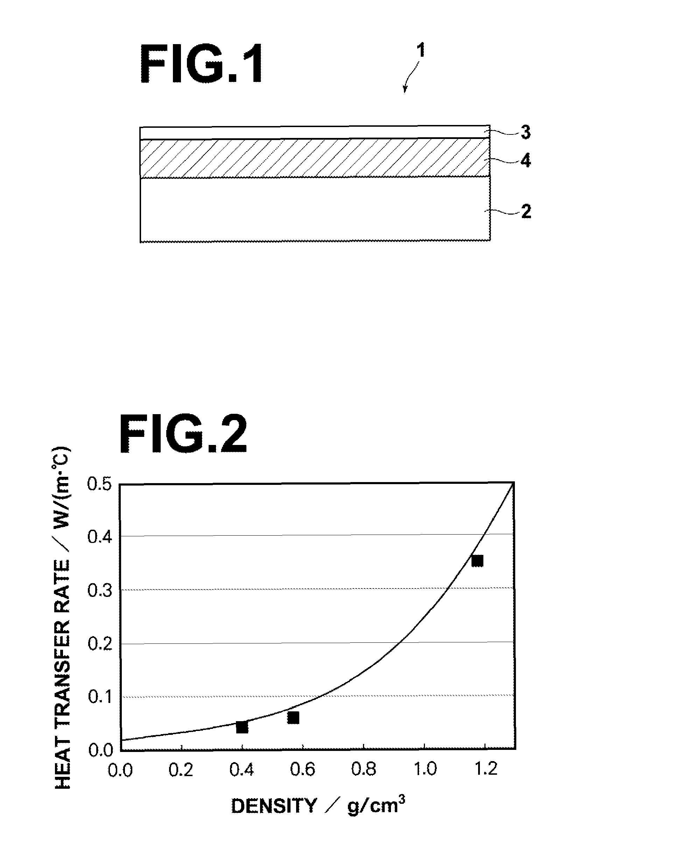

Hereinafter, a semiconductor device according to the first invention will be described with reference to the attached drawings. Figure 1 is a schematic sectional view that illustrates a semiconductor device 1 according to an embodiment of the first invention. As illustrated in Figure 1, the semiconductor device 1 is of a configuration in which a porous structure layer 4 (hereinafter, also referred to as "silicone resin layer 4") formed by silicone resin is provided between a substrate 2 and a semiconductor element layer 3.

The silicone resin layer 4 employed in the first invention is a silicone resin represented by the general formula $(R^1R^2R^3SiO_{0.5})_W$ $(R^4R^5SiO)_X$ $(R^1SiO_{1.5})_Y$ $(SiO_2)_Z$. It is preferable for the percentage of the combined $(R^6SiO_{1.5})$ back-bone and $(SiO_2)$ backbone to be 95% by mass or greater of the total mass of the silicone resin, and for the percentage of the $(R^6SiO_{1.5})$ backbone with respect to the combined mass of the $(R^6SiO_{1.5})$ backbone and the $(SiO_2)$ backbone to be 20% by mass or greater. In the above general formula, $(R^1R^2R^3SiO_{0.5})$, $(R^4R^5SiO)$, $(R^6SiO_{1.5})$, and $(SiO_2)$ are basic backbone structures referred to as M siloxane, D siloxane, T siloxane (or silsesuioxane), and Q siloxane (or simply siloxane), respectively. The silicone resin is a copolymer of these backbone structures. Among these, the backbones other than the siloxane backbone have R groups which are not siloxane bonded, and therefore the silicone resin has a certain degree of flexibility. For this reason, even if the substrate is a flexible substrate, such as a resin substrate, the silicone resin layer 4 will not impede the flexibility of the substrate. In addition, because the silicone resin layer 4 is a porous structure, it is possible to impart a greater degree of flexibility to the substrate.

Among the ratios of the basic backbones indicated by W through Z in the general formula above, problems of heat resistance will occur in cases that W (M siloxane) and X (D siloxane) are high, and therefore it is preferable for these backbones to not be included. Even in the case that these backbones are unavoidably included in raw material monomers, it is preferable for these backbones to be included at less than 5% by mass of the total mass of the silicone resin. It is preferable for Y (silsesquioxane) and Z (siloxane) to be high, and for these two components to be the main components of the composition, due to the high heat resistance properties thereof. However, as described previously, the siloxane backbone is rigid. Therefore, if the ratio of Z is excessively high, the heat insulating layer formed as a film on the substrate will lack flexibility. As a result, cracks may form in the silicone resin layer 4 if bending strain or thermal history is applied during the steps for producing the semiconductor device. Accordingly, it is preferable for the silsesquioxane backbone to be included at 20% by mass or greater and for the siloxane backbone to be included at less than 80% by mass in the silicone resin.

$R^1$ through $R^5$ are hydrocarbyl groups, halogen substituted hydrocarbyl groups, alkenyl groups, or hydrogen having 1 to 10 carbon atoms, and more preferably having 1 to 6 carbon atoms. Heterocyclic hydrocarbyl groups and halogen substituted hydrocarbyl groups that include at least three carbon atoms may have branching structures or non branching structures. Examples of the hydrocarbyl group represented by R include: alkyl groups, such as methyl, ethyl, propyl, 1-methylethyl, butyl, 1-methylproppyl, 2-methylpropyl, 1,1-dimethyletyl, pentyl, 1-methylbutyl, 21-ethylpropryl, 2-methylbutyl, 3-methylbutyl, 1,2-dimethylpropyl, 2,2-dimethylpropyl, hexyl, heptyl, octyl, nonyl, and decyl; cycloalkyl groups, such as cyclopentyl, cyclohexyl, and methylcyclohexyl; aryl groups, such as phenyl and naphthyl; and aralkyl groups, such as benzyl and phenethyl.

Preferred examples of halogen substituted hydrocarbyl groups include: 3, 3, 3-trifluoropropyl; 3-chloropropyl; chlorophenyl; dichlorophenyl; 2, 2, 2-trifluoroethyl; 2, 2, 3, 3-tetrafluoroproyl; and 2, 2, 3, 3, 4, 4, 5, 5-octafluoropentyl.

Alkenyl groups generally have 2 to 10 carbon atoms, or 2 to 6 carbon atoms, and preferred examples include: vinyl; aryl; butenyl; hexenyl; and octenyl.

From among the aforementioned silsesquioxanes, methyl silsesquioxane $(CH_3SiO_{1.5})$ or phenyl silsesquioxane $(C_6H_5SiO_{1.5})$ are preferred from the viewpoint of heat resistance. In the semiconductor device of the first invention, it is necessary for the silicone resin layer 4, which is to function as a heat resisting layer, to have heat resistant properties. From among polysilsesquioxanes the two polysilsesquioxane above have decomposition temperatures of 400°C or greater. Note that methyl silsesquioxane and phenyl silsesquioxane need not be unitary compositions, but may be composites with each other, or may be composites with the ($SiO_2$) Q siloxane composition. However, if the ratio of the ($SiO_2$) Q siloxane composition becomes high, problems with respect to flexibility will arise, as described previously. Therefore, it is preferable for the ($SiO_2$) Q siloxane composition to be included at less than 80% by mass.

It is preferable for the density of the porous structure silicone resin layer to be $0.7g/cm^3$ or less, and more preferably to be within a range from $0.1g/cm^3$ to $0.7g/cm^3$. If the density of the silicone resin layer becomes greater than $0.7g/cm^3$, the heat transfer rate will increase, and the substrate may be affected by heating of the semiconductor element layer during annealing or the like, depending on the material thereof. Meanwhile, if the density of the silicone resin layer is less than $0.1g/cm^3$, the adhesion properties with respect to the substrate will deteriorate depending on the material thereof. In addition, it will become difficult for the silicone resin layer to have structural strength suited for a semiconductor device.

The density of the porous silicone resin layer may be obtained by the nitrogen adsorption measurement method (BET), for example. The nitrogen adsorption measurement method is capable of measuring pore diameters and pore volumes $V[cm^3/g]$. If $\rho[g/cm^3]$ is designated as the true density of the porous silicone resin layer, from which the pores have been removed, the porosity and density of the porous silicone resin layer of the first invention can be calculated from the following Formulas (1) and (2).

$$\text{Porosity:} \quad \rho V/(\rho V+1) \quad\quad\quad (1)$$

$$\text{Density:} \quad \rho/(\rho V+1) \, [g/cm^3] \quad\quad\quad (2)$$

Note that the true density of polymethyl silsesquioxane is known to be approximately $1.3g/cm^3$ to $1.33g/cm^3$ ("New Transparent Methylsilsesquioxane Aerogels and Xerogels with Improved Mechanical Properties", K. Kanamori et al., Advanced Materials, Vol. 19, Issue 12, pp. 1589-1593, 2007).

It is preferable for the porosity of the porous silicone resin layer to be 40% or greater, and more preferably to be within a range from 40% to 95%. In the case that the substrate is a resin substrate and the porosity is less than 40%, the heat transfer rate of the silicone resin layer will become lower than 0.2 (W/ (me•$\underline{o}$C), which is a common heat transfer rate for resins, and is likely to be affected by heating of the semiconductor element layer during annealing or the like. On the other hand, if the porosity is greater than 95%, the adhesion properties with respect to the substrate will deteriorate depending on the material thereof. In addition, it will become difficult for the silicone resin layer to have structural strength suited for a semiconductor device.

If the apertures that function as pores are too large, problems may occur with respect to the smoothness of the surface of the film. Therefore, it is preferable for the pore diameters to be 100nm or less. On the other hand, if the pore diameters are too small, the density of the silicone resin layer will decrease, and it will become difficult to obtain a silicone resin layer having structural strength suited for a semiconductor device, depending on the material of the substrate. Accordingly, the preferred range of pore diameters is from 1nm to 100nm, and more preferably from 2nm to 50nm. It is possible to measure the pore diameters by the aforementioned nitrogen adsorption measurement method. Alternatively, the pore diameters may be derived by image processing administered on a transmission electron microscope image.

Note that nitrogen molecules cannot be adsorbed onto blocked pores and pores having diameters of several nm or less. Therefore, it is not possible to measure such pores by the aforementioned nitrogen adsorption measurement method. However, the porous silicone resin layer of the first invention is constituted substantially entirely by open pores having diameters of 5nm or greater, and there are no practical problems in obtaining the density thereof by the nitrogen adsorption measurement method. Note that the density and pore volume may alternatively be measured by the Archimedes method, by a pycnometer, byX ray reflectivitymeasurement, by an ellipsometer, by dielectric measurement, by position electron age measurement, etc.

The thickness of the silicone resin layer differs depending on the density and the heat transfer rate of the porous structure, necessary annealing temperatures, and employed heating methods. However, a thickness of $1\mu m$ or greater will enable the silicone resin layer to function sufficiently as a heat insulating layer which is not influenced by heating of the semiconductor element layer during annealing or the like.

The porous silicone resin layer of the first invention may be formed as a film by a sol gel reaction using a surfactant, a CVD method using cyclic siloxane monomers as a raw material, or the like. Particularly, the sol gel reaction that uses a surfactant employs the surfactant as a template for forming the porous structure is a comparatively inexpensive and a low temperature production method. Therefore, this method is suited for producing a heat insulating layer on a substrate using a general use resin as a base material over large areas. The sol gel reaction that uses a surfactant can be executed according to the method disclosed in "New Transparent Methylsilsesquioxane Aerogels and Xerogels with Improved Mechanical Properties", K. Kanamori et al., Advanced Materials, Vol. 19, Issue 12, pp. 1589-1593, 2007, for example.

Preferred surfactants are those having comparatively large molecular weights. Examples of such surfactants are those that have 10 or more carbon atoms at alkyl groups, block copolymers having molecular weights of approximately 10,000, and the like. Micelles are formed using such surfactants, to form a template for the porous structure. The surfactant is not particularly limited as long as it satisfies the above condition. The surfactant may be cationic, anionic, or nonionic. Specific examples of suitable surfactants include: chlorides, such as alkyl trimethyl ammonium, alkyl triethyl ammonium, dialkyl dimethyl ammonium, and benzyl ammonium; bromides; iodides; hydroxides; fatty acid salts; alkyl sulfonate; alkyl phosphate; polyol series nonionic surfactants; polyethylene oxide series nonionic surfactants; and primary alkyl amines. These surfactants may be used either singly or in combinations of two or more types mixed together.

Metal, ceramic, glass, resin, etc. may be employed as the material of the substrate 2, which is a supporting base material. Resin substrates may be favorably used as a substrate for a lightweight flexible semiconductor device that fully utilizes the functions of the heat insulating layer. Examples of resin materials for the resin substrate include: polyethylene terephthalate (PET); polyethylene naphthalate (PEN); polyimide (PT) ; triacetyl cellulose (TAC); syndiotactic polystyrene (SPS); polyphenylene sulfide (PPS); polycarbonate (PC); polyarylate (PAr); polysulfone (PSF) ; polyester sulfone (PES); polyetherimide (PEI); and cyclic polyolefin.

By providing the silicone resin layer 4, it is possible to heat only the semiconductor element layer 3 without raising the temperature of the substrate 2, even in cases that materials having low heat resistance, such as PET, PEN, and PI are used as the material of the resin substrate. In addition, in cases that flexible substrates are employed, semiconductor devices having such substrates can be used as flexible displays, flexible thin film solar batteries, etc. in addition, silicone resin having mesopores having diameters of 100nm or less is transparent. Therefore, by combining the transparent silicone resin with oxide semiconductors such as IGZO and conductive oxides such as ITO and ZnO, visibly transparent flexible semiconductor devices can be realized.

Next, a method for producing the semiconductor device of the first invention will be described. The silicone resin layer 4 is provided on the substrate as described above, the semiconductor element layer 3 is provided on the porous structure layer, the device is heated intermittently only from the side of the semiconductor element layer 3. The silicone resin layer 4 is a porous structure and has a heat insulating function. Therefore, if heating is performed form the side of the semiconductor element layer 3, a heat transfer delay phenomenon occurs due to a large thermal time constant based on the low heat transfer rate of the silicone resin layer 4. Accordingly, it is possible to apply a sufficient amount of heat necessary to improve the performance of semiconductors before the temperature of the substrate 2 rises. Note that it is necessary to perform processes to the semiconductor element layer 3 according to the semiconductor device to be produced, such as etching, and adding further layers (an electrode layer, for example). However, it is possible to perform heating at an appropriate timing during the production process. In addition, the heating may be performed not only to improve the performance of the semiconductor, but to reduce remaining stress that may result in bowing of the semiconductor device. It goes without saying that adding layers having poor heat resistance should be avoided prior to heating.

For example, in the case that the semiconductor is IGZO (nGaZnO), the semiconductor element layer 3 is formed on the porous structure layer by the vapor deposition method, the sputter vapor deposition method, the ion plating method, the chemical vapor deposition (CVD) method, or the like. Then; the intermittent heating is performed on the IGZO only from the side that the IGZO is provided on. Generally, IGZO semiconductor elements formed at room temperature exhibit small degrees of carrier motility, and fluctuations in the properties thereof. In contrast, the semiconductor device of the first invention has the porous low density silicone resin layer between the substrate and the semiconductor element layer, which enables annealing to be performed at temperatures of 300°C to 400°C. Thereby, the degree of carrier motility can be improved, and the properties of the semiconductor device can be stabilized. For this reason, the semiconductor device of the first invention may also be favorably applied to liquid crystals and TFT panels for organic EL's.

In addition, in the case that the semiconductor device is a solar battery in which a semiconductor compound is employed as a light absorbing layer, fine particles of the semiconductor compound may be coated onto the silicone resin layer. Then, by administering high speed heat processes with respect to the fine particles of the semiconductor compound only from the side of the coated surface, the fine particles will be sintered and can function as a light absorbing layer.

Light or electron beam irradiation, for example, may be employed to perform the intermittent heating. Even if this type of heat process is performed, because the porous silicone resin functions as a heat insulating layer to generate delays in heat transfer, heating while suppressing temperature increases of the substrate becomes possible in the method for producing the semiconductor device of the first invention.

Here, the intermittent heating refers to the amount of time that the porous silicone resin functions as a heat insulating layer. In cases that the total heating time for the semiconductor exceeds the amount of time that the porous silicone resin functions as a heat insulating layer, heating is performed by dividing up the heating time. For example, in the case that a total necessary heating time for the semiconductor is 1 second, and the amount of time that the porous silicone resin functions as a heat insulating layer is 0.1 seconds, heating for 0.1 seconds is intermittently repeated 10 times.

It is preferable for a heating means to be that which performs intermittent heating using light or an electron beam. The intermittent heating need not be performed at nanosecond intervals, and intermittent heating in millisecond intervals is sufficient. In the case that the heating means uses light, solid state lasers such as YAG and semiconductor lasers may be employed instead of an excimer laser. Further, the light is not limited to a laser, but may be provided by a flash lamp, such as a xenon lamp. It is preferable for the wavelength of the heating light to be within the absorption range of the material to be heated.

Hereinafter, the semiconductor device of the first invention and the method for producing the semiconductor device will be described in greater detail.

[Embodiments of the First Invention]

(Embodiment 1)

15 parts of a 10mM acetic acid solution, 2 parts of Pluronic F-127 (a block copolymer surfactant by BASF), 1 part urea, and 9 parts methyltrimethoxysilane were mixed to obtain a transparent solution. The solution was placed in a semi hermetically sealed Teflon™ container, and gelatinization reactions were performed for two days at 80°C. The surfactant was cleansed and removed from the wet gel in boiling water, and solvent substitution was performed with a methanol and fluorine solvent (Novec-7100 by Sumitomo 3M). The gel was dried to obtain a transparent dry gel porous structure formed by polymethyl silsesquioxane. The density $\rho$ of the dry gel as measured by the Archimedes method was $0.40 \text{g/cm}^3$.

(Embodiment 2)

A semitransparent dry gel formed by polymethyl silsesquioxane was obtained by the same steps as Embodiment 1, except that the amount of Pluronic F-127 was changed to 1.5 parts. The density $\rho$ of the dry gel as measured by the Archimedes method was $0.57 \text{g/cm}^3$.

(Embodiment 3)

A transparent dry gel formed by a copolymer of methyl silsesquioxane and siloxane was obtained by the same steps as Embodiment 1, except that the transparent solution was obtained by mixing 35 parts of a 10mM acetic acid solution, 16 parts of tetramethoxysilane, 10 parts of methyltrimethoxysilane, 5.5 parts of Pluronic F-127, and 2.5 parts urea. The siloxane backbone/silsesquioxane backbone weight ratio calculated from the mixture ratio is 61/39. The density $\rho$ of the dry gel as measured by the Archimedes method was $0.40 \text{g/cm}^3$.

(Comparative Example 1)

A semitransparent dry gel formed by polymethyl silsesquioxane was obtained by the same steps as Embodiment 1, except that Pluronic F-127 was not used. The density $\rho$ of the dry gel as measured by the Archimedes method was $1.18 \text{g/cm}^3$.

(Evaluation)

The porosity and the density of samples of Embodiments 1 through 3 were obtained by Formula (1) and Formula (2) described previously, from pore volumes derived from nitrogen adsorption isothermal lines of BET measurement. The results are shown in Table 1. Calculations were performed assuming that the true density of silicone resin was $1.3 \text{g/cm}^3$. In embodiments 1 through 3, porous silicone resins with mesopores having pore diameters of approximately 30nm were obtained. In addition, it can be seen that the densities obtained by BET and the densities obtained by the Archimedes method substantially match. Note that with respect to a sample of Comparative Example 1, the pores and pore volume thereof were beneath the detection limit of the BET method.

TABLE 1

|  | Embodiment 1 | Embodiment 2 | Embodiment 3 |
|---|---|---|---|
| Mean Pore Diameter (nm) | 32 | 25 | 28 |
| Pore Volume (cm$^3$/g) | 1.6 | 0.9 | 1.8 |
| Porosity (%) | 68 | 54 | 70 |
| Density: BET Method (g/cm$^3$) | 0.42 | 0.60 | 0.39 |
| Density: Archimedes Method (g/cm$^3$) | 0.40 | 0.57 | 0.40 |

The samples obtained for Embodiments 1 through 3 and Comparative Example 1 were ground to a thickness of approximately 0.3mm, and the thermal diffusivity coefficients thereof were measured by the laser flash method (using TC-9000 by Ulvac Riko). Heat transfer rates $\lambda$ of the samples were calculated according to the formula $\lambda = \rho \cdot C \cdot \alpha$, using values of weight specific heat C measured by a DSC (Differential Scanning Calorimeter 2920 by TA Instruments) which were measured separated. The heat transfer rates of Embodiments 1 through 3 and Comparative Example 1 were 0.043, 0.059, 0.095, and 0.353 (W/ (m•°C)), respectively.

Generally, the heat transfer rates of solid materials having pores is represented by Braggemann's formula below (in the formula, $\varphi$ is the volume filling rate of the silicone resin, $\lambda f$ is the heat transfer rate of the silicone resin, $\lambda c$ is the heat transfer rate of the porous layer, and $\lambda m$ is the heat transfer rate of air within the porous layer) . The index number m is 1/3 in cases that heat transfer components undergo percolative conduction in a spherical shape.

$$1 - \phi = \frac{\lambda c - \lambda f}{\lambda m - \lambda f} \left[ \frac{\lambda m}{\lambda c} \right]^{1/3}$$

If the measurement results of the samples are plotted, designating the heat transfer rates of air in the pore portions as 0.024W/(m•$\underline{o}$C) the relationship between heat transfer rates and density is that illustrated in Figure 2 (note that in Figure 2, the plots of Embodiments 1 and 3 are overlapped). It can be seen that the relationship substantially.matches the Braggemann's formula. It can also be seen that the heat transfer rate becomes half or less than 0.2W/ (m•$\underline{o}$C) , which is a common heat transfer rate for resins, if the density is 0.7g/cm$^3$ or less, indicating that the silicone resin layer effectively functions as a heat insulating layer, even if the resin substrate has low heat resistance.

The following experiments were performed to confirm that the porous structure formed by silicone resin functions as a heat insulating layer against heating during production of semiconductor devices.

(Embodiment 11)

A solution, containing 10 parts of 3-glysidoxyproppyltrimethoxysilane, 10 parts of phenyltriethoxysilane, 0.2 parts of aluminum acetylacetonate, 2 parts hydrochloric acid, and 5 parts water was produced, and coated on a UV ozone processed PEN film having a thickness of 100$\mu$m by the spin coat method. Thereafter, the coating film was dried at 100°C, and maintained at 170°C for an hour to perform curing and desolvation and an adhesion layer was obtained. When the cross section of the adhesion layer was observed by an SEM, the thickness thereof was approximately 0.1$\mu$m, and no pores were observed.

A coating film was formed by the doctor blade method on the PEN film with the adhesion layer, using the solution of Embodiment 1. The coated PEN film was placed in a semi hermetically sealed Teflon™ container, and gelatinization reactions were performed for two days at 80°C in an ammonia atmosphere. The same processes that were administered onto the dry gel of Embodiment 1 were administered onto the obtained film with the gel film coated thereon, and a dry gel film formed by polymethyl silsesquioxane having a thickness of 10$\mu$m was obtained.

(Embodiment 12)

After forming an adhesion layer in the same manner as in Embodiment 11, a dry gel film formed by polymethyl silsesquioxane having a thickness of 10$\mu$m was obtained in the same manner as Embodiment 11, except that the solution of Embodiment 2 was employed.

(Embodiment 13)

After forming an adhesion layer in the same manner as in Embodiment 11, a dry gel film formed by formed by a copolymer of methyl silsesquioxane and siloxane having a thickness of 10μm was obtained in the same manner as Embodiment 11, except that the solution of Embodiment 3 was employed.

(Comparative Example 11)

After forming an adhesion layer in the same manner as in Embodiment 11, a dry gel film formed by polymethyl silsesquioxane having a thickness of 10μm was obtained in the same manner as Embodiment 11, except that the solution of Comparative Example 1 was employed.

(Evaluation)

The densities of the samples of Embodiments 11 through 13 were calculated from pore volumes derived from nitrogen adsorption isothermal lines of BET measurement in the same manner as that for Embodiments 1 through 3. The results are shown in Table 2. Because the volume of the film portion is small, it is not possible to measure density using the Archimedes method. However, because dry gel films obtained from the same mixed solutions yield substantially the same average pore diameters and densities, porous silicone resin films with mesopores having pore diameters of approximately 30nm were obtained. Note that with respect to a sample of Comparative Example 11, the pores and pore volume thereof were beneath the detection limit of the BET method, as for the sample of Comparative Example 1.

TABLE 2

|  | Embodiment 11 | Embodiment 12 | Embodiment 13 |
|---|---|---|---|
| Mean Pore Diameter (nm) | 30 | 27 | 32 |
| Pore Volume (cm$^3$/g) | 1.5 | 0.9 | 1.8 |
| Porosity (%) | 66 | 54 | 70 |
| Density: BET Method (g/cm$^3$) | 0.44 | 0.60 | 0.40 |

Zn films having thicknesses of 0.5μm were formed on the dry gel films of the samples obtained in Embodiments 11 through 13 and Comparative Example 11. A semiconductor laser emitting a laser beam with a wavelength of 808nm and an irradiation surface intensity of 100W/cm$^2$ was irradiated for 30 milliseconds once, and also irradiated for 30 milliseconds 10 times at 0.5 second intervals. When the Zn surfaces of the irradiated samples were observed with an optical microscope, the surfaces were roughened in the Embodiments both after the single irradiation and after the 10 intermittent irradiations, and it was recognized that the Zn had fused. However, in the Comparative Example, the surface was the same following the 10 intermittent irradiations as it was prior to irradiation, and Zn fusion was not confirmed. The melting point of Zn is 419°C, and therefore it may be judged that the dry gel films formed by porous silicone resin function effectively as heat insulating layers in the Embodiments. Note that no abnormalities were observed on the PEN surface in any of the samples, nor were any deformations such as bowing observed.

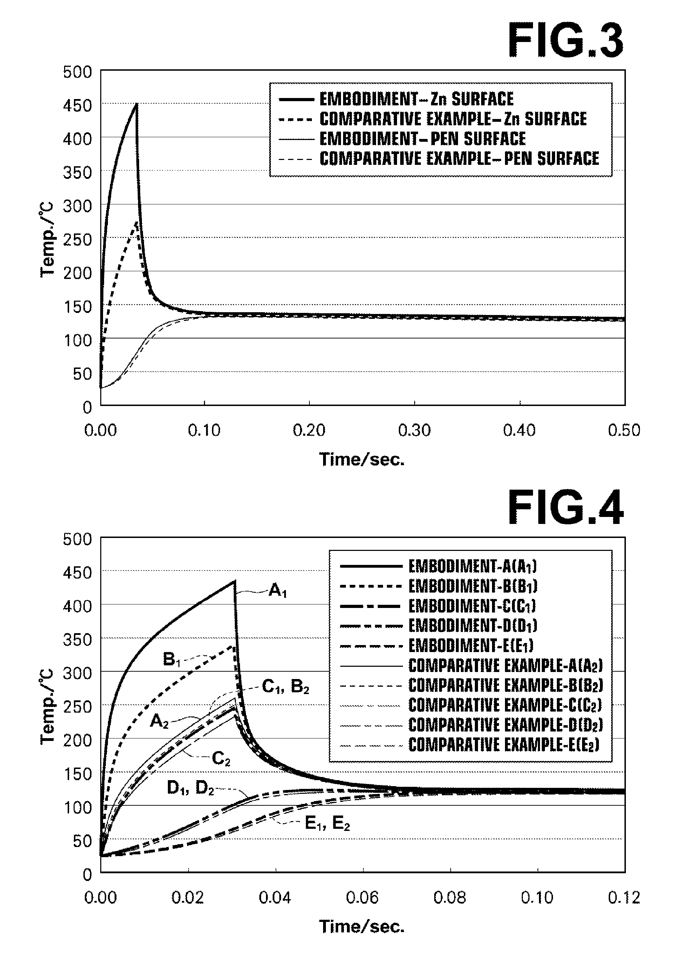

One dimensional heat conduction analyses were performed using the thermal network method, in order to estimate changes in sample temperature during heating. Documented values were utilized as the values of thermo physical properties (density, volume specific heat, and heat transfer rate) of Zn and PEN, and measured values obtained from Embodiment 1 and Comparative Example 1 were employed for the dry gel films. Heating was performed for 30 milliseconds at an intensity of 100W/cm$^2$ on the surfaces of the Zn films. With respect to heat dissipation, the thermal emissivity of the Zn surfaces was designated as 0.3, and the thermal emissivity of the PEN surfaces was designated as 0. 9. The Zn film, which simulates a semiconductor circuit layer 3, the heat insulating layer 4, and the Pen substrate 2 were divided into thermal circuit elements in the thickness directions thereof. Figure 3 is a graph that illustrates calculated heat transfer and transient temperatures of each thermal circuit element in 5 millisecond increments. Figure 4 is a graph that illustrates calculated heat transfer and transient temperatures of each thermal circuit element in 0.5 millisecond increments. Note that the "Embodiment" and the "Comparative Example" in Figures 3 and 4 refer to Embodiment 11 and Comparative Example 11.

In Figure 3, the maximum surface temperature of the Zn film of the Embodiment is approximately 440°C, whereas the maximum surface temperature of the Zn film of the Comparative Example is only approximately 260°C. There is no great difference in the PEN surface temperatures of the Embodiment and the Comparative Example. The temperatures of the PEN surfaces rise at a slower pace compared to that of the Zn films and reach a maximum temperature of approximately 140°C, but the temperature of the entireties of the devices become substantially uniform after approximately 0.1 seconds, and it can be understood that the devices are undergoing radiant cooling. From these results, it is judged that it is possible to increase only the Zn surface temperature to the melting temperature of Zn in the Embodiment, because the porous structure layer formed by silicone resin has a low heat transfer rate. In comparison, the heat transfer rate is high in the Comparative Example, and the melting temperature of Zn was not reached. In addition, in order to increase the Zn surface temperature to the melting temperature thereof in the Comparative Example, it is necessary to increase the heating time, for example. However, in this case, because the PEN surface temperature also increases with an approximate 30 millisecond delay, it is estimated that the temperature of the PEN film will exceed its upper temperature limit.

Changes in temperature distribution over time during asymmetrical heating are illustrated in the graph of Figure 4. In the graph, A denotes the Zn surface, B denotes the center of the heat insulating layer formed by silicone resin, C denotes the interface between the heat insulating layer and the PEN film, D denotes the center of the PEN film, and E denotes the PEN surface. The subscript 1 denotes the Embodiment, and the subscript 2 denotes the Comparative Example.

As is clear from the graph, there is no great difference in the temperature distribution and the changes therein of the PEN portions ($D_1$, $D_2$, $E_1$, and $E_2$) during heating up to the time at which the temperatures of the entireties of the devices become substantially uniform. In contrast, the temperature distribution of the Zn surface and the heat insulating layer ($A_1$, $B_1$) is great in the Embodiment, and small in the Comparative Example ($A_2$, $B_2$). For this reason, the Zn surface temperature ($A_1$) of the Embodiment is higher than the Zn surface temperature ($A_2$) of the Comparative Example, From these results, it can be understood that thermal annealing at temperatures of 400°C or greater is possible in the Embodiment, because the porous structure layer formed by silicone resin functions as a heat insulating layer.

Results that indicate that if the heat transfer rate of a heat insulating layer is 0.1W/(m•°C) or less and the layer thickness is 1μm or greater, a temperature difference of 50°C or greater can be generated between the temperature at the interface ($C_1$) between the insulating layer and a PEN film and the temperature at the Zn surface ($A_1$) were obtained from a similar heat transfer simulation. From the relationship between the heat transfer rates and densities of Embodiments 1 and 2, the heat transfer rate will become 0.1W/ (m•°C) or less if the density of the silicone resin is $0.7g/m^3$ or less. Therefore, thermal annealing at temperatures 50°C greater than the upper temperature limit of a standard resin substrate is enabled.

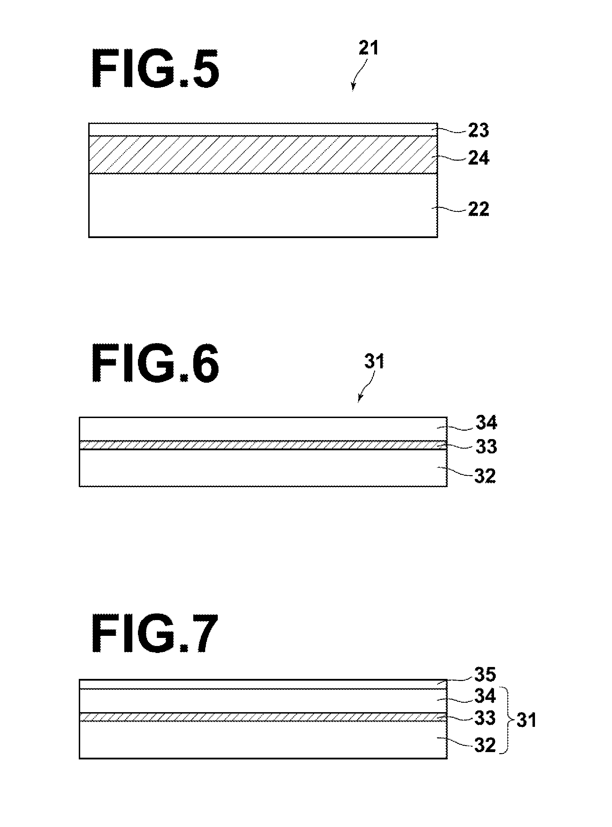

Hereinafter, a semiconductor device according to the second invention will be described with reference to the attached drawings. Figure 5 is a schematic sectional view that illustrates a semiconductor device 21 according to an embodiment of the second invention. As illustrated in Figure 5, the semiconductor device 21 is of a configuration in which a porous layer 24 having a density of $0.7g/cm^3$ or less, formed by a compound obtained by hydrolyzing and condensing at least one type of alkoxysilane selected from a group consisting of monoalkoxysilane, dialkoxysilane, and trialkoxysilane, and tetraalkoxysilane, is provided between a substrate 22 and a semiconductor layer 23. The substrate 22 and the porous layer 24 function as a substrate for the semiconductor element 23 (hereinafter, the layered structure including the substrate 22 and the porous layer 24 will also be collectively referred to as "a substrate for a semiconductor element").

The porous layer of the second invention includes tetraalkoxysilane as an essential component. The tetraalkoxysilane enables the percentage of siloxane bonds within the compound obtained by the hydrolysis/condensation reaction to increase, and as a result, can increase the modulus of elasticity. The improvement in the modulus of elasticity reduces the amount of temporary shrinkage during drying of the film that forms the porous layer and reduces tensile stress applied to the film. Thereby, it becomes possible to prevent cracks from forming in the porous layer.

It is preferable for the density of the porous layer 24 to be $0.7g/cm^3$ or less, and more preferably to be within a range from $0.1g/cm^3$ to $0.7g/cm^3$. If the density of the porous layer becomes greater than $0.7g/cm^3$, the heat transfer rate will increase, and the substrate may be affected by heating of the semiconductor element layer during annealing or the like, depending on the material thereof. Meanwhile, if the density of the porous layer is less than $0.1g/cm^3$, the adhesion properties with respect to the substrate will deteriorate depending on the material thereof. In addition, it will become difficult for the porous layer to have structural strength suited for a semiconductor device.

The density of the porous layer may be obtained by the nitrogen adsorption measurement method (BET), for example. The nitrogen adsorption measurement method is capable of measuring pore diameters and pore volumes V [$cm^3/g$]. If $\rho$[$g/cm^3$] is designated as the true density of the porous layer, from which the pores have been removed, the porosity and density of the porous layer of the second invention can be calculated from the following Formula (3).

$$\text{Density:} \quad \rho/(\rho V+1) \, [g/cm^3] \qquad\qquad (3)$$

Note that the true density of polymethyl silsesquioxane is known to be approximately 1.3g/cm$^3$ to 1.4g/cm$^3$ ("New Transparent Methylsilsesquioxane Aerogels and Xerogels with Improved Mechanical Properties", K. Kanamori et al., Advanced Materials, Vol. 19, Issue 12, pp. 1589-1593, 2007).

If the apertures that function as pores are too large, problems may occur with respect to the smoothness of the surface of the film. Therefore, it is preferable for the pore diameters to be 100nm or less. On the other hand, if the pore diameters are too small, the density of the silicone resin layer will decrease, and it will become difficult to obtain a silicone resin layer having structural strength suited for a semiconductor device, depending on the material of the substrate. Accordingly, the preferred range of pore diameters is from 1nm to 100nm, and more preferably from 2nm to 50nm. It is possible to measure the pore diameters by the aforementioned nitrogen adsorption measurement method. Alternatively, the pore diameters may be derived by image processing administered on a transmission electron microscope image.

Note that nitrogen molecules cannot be adsorbed onto blocked pores and pores having diameters of several nm or less. Therefore, it is not possible to measure such pores by the aforementioned nitrogen adsorption measurement method. However, the porous silicone resin layer of the first invention is constituted substantially entirely by open pores having diameters of several 10's of nanometers or greater, and there are no practical problems in obtaining the density thereof by the nitrogen adsorption measurement method. Note that the density and pore volume may alternatively be measured by the Archimedes method, by a pycnometer, by X ray reflectivity measurement, by an ellipsometer, by dielectric measurement, by position age measurement, etc.

The thickness of the silicone resin layer differs depending on the density and the heat transfer rate of the porous structure, necessary annealing temperatures, and employed heating methods. However, a thickness of 1μm or greater will enable the silicone resin layer to function sufficiently as a heat insulating layer which is not influenced by heating of the semiconductor element layer during annealing or the like.

The alkoxysilane (a monomer which is a starting material) employed in the porous layer is at least one type of alkoxysilane selected from a group consisting of monoalkoxysilane having one alkoxy group, dialkoxysilane having two alkoxy groups, and trialkoxysilane having three alkoxy groups, and tetraalkoxysilane having four alkoxy groups. The types of the alkoxy groups are not particularly limited. However, alkoxy groups having comparatively small numbers of carbon atoms (carbon numbers from 1 to 4), such as methoxy groups, ethoxy groups, propoxy groups, and butoxy groups are advantageous from the viewpoint of reactive properties. In the case that trialkoxysilane or dialkoxysilane is employed, organic groups, hydroxyl groups, and the like may be bonded to the silicon atoms within the alkoxysilane. The organic groups may further have functional groups, such as epoxy groups, amino groups, mercapto groups, and vinyl groups.

Preferred examples of monoalkoxysilanes include: trimethylmethoxysilane; trimethylethoxysilane; and 3-chloropropyldimethylmethoxysilane.

Preferred examples of dialkoxysilanes include: dimethoxydimethylsilane; dimethoxydimethylsilane; dimethoxy-3-glycidoxydipropylmethylsilane; dimethoxydiphenylsilane, and dimethoxydimethylphenylsilane.

Preferred examples of trialkoxysilanes include: methyltrimethoxysilane; propyltrimethoxysilane; hexyltrimethoxysilane; octadecyltrimethoxysilane; phenyltrimethoxysilane; aryltrimethoxysilane; vinyltrimethoxysilane; cyanopropyltrimethoxysilane; 3-bromopropyltrimethoxysilane; 3-chloropropyltrimethoxysilane; 2-(3, 4-epoxycyclohexyl) ethyltrimethoxysilane; 3-glycidyloxypropyltrimethoxysilane; 3-iodopropyltrimethoxysilane; 3-mercaptopropyltrimethoxysilane; trimethoxy [2-(7-oxabicyclo [4, 1, 0] hepto-3-yl) ethyl] silane; 1-[3-(trimethoxysilyl) propyl] urea; N-[3-(trimethoxysilyl) propyl] anylene; trimethoxy [3-phenylaminopropyl] silane; acryloxypropyltrimethoxysilane; methacryloxypropyltrimethoxysilane; trimethoxy [2-phenylethyl] silane; trimethoxy (7-octen-1-yl) silane; trimethoxy (3,3,3-trifluoropropyl) silane; 3-[2-(2-aminoethylamino) ethylamino] propyltrimethoxysilane; [3-(2-aminothylamino) propyl] trimethoxysilane; 3-glysidoxypropyltrimethoxysilane; 3-aminopropyltrimethoxysilane; 3-diethylaminopropyltrimethoxysilane; bis (3-methylamino) propyltrimethoxysilane; N,N-dimethylaminopropyltrimethoxysilane; N-[3-(trimethoxylsilyl) propyl] ethylenediamine; trimethoxy (3-methylamino) propylsilane; methyltrimethoxysilane; propyltriethoxysilane; octadecyltriethoxysilane; phenyltriethoxysilane; aryltriethoxysilane; (1-naphtyl) triethoxysilane; [2-(cyclohexenyl) ethyl] triethoxysilane; 3-aminopropyltriethoxysilane; 3-[bis(2-hydroxyethyl) amino] propyltriethoxysilane; 3-chloropropyltriethoxysilane; 3-glycidyloxypropyltriethoxysilane; 3-mercaptopropyltriethoxysilane; 4-chlorophenyltriethoxysilane; (bicyclo [2,2,1] hepto-5-en-2-yl) triethoxysilanel; chloromethyltriethoxysilane; pentafluorophenyltriethoxysilane; 3-(triethoxysilyl) propyonitryl; 3-(triethoxysilyl) propylisocyanate; bis [3-triethoxysilylpropyl] tetrasulfide; triethoxy (3-isocyanatopropyl) silane; and triethoxy (3-thioisocyanatopropyl) silane.

It is preferable for the at least one type of alkoxysilane to be trialkoxysilane, from the viewpoint of increasing the modulus of elasticity of the porous layer to a certain degree to reduce the amount of temporary shrinkage when the film is being dried, thereby decreasing the tensile stress applied thereto. It is preferable for the at least one type of alkoxysilane to be methyltrialkoxysilane, from the viewpoint of speed of the hydrolysis reaction.

Preferred examples of the tetraalkoxysilanes include: tetramethoxysilane; tetraethoxysilane; tetraisopropoxysilane; and dimethoxydiethoxysilane.

Ceramics, such as alumina, silica, zirconia, titania, and magnesia; glass; resin; etc. may be employed as the material of the substrate. Examples of resin materials for a resin substrate include: polyethylene terephthalate (PET); polyethylene naphthalate (PEN); polyimide (PI); triacetyl cellulose (TAC); syndiotactic polystyrene (SPS); polyphenylene sulfide (PPS); polycarbonate (PC); polyarylate (PAr); polysulfone (PSF); polyester sulfone (PES); polyetherimide (PEI); and cyclic polyolefin.

The detailed configuration of the semiconductor element 23 differs according to the semiconductor device in which it is used, and in actuality is a complex structure. Figure 5 merely illustrates the relationship between the substrate and the semiconductor element. However, in the case that the semiconductor device is a thin film transistor circuit, the semiconductor element 23 is a pixel switching element. In the case that the semiconductor device is a solar battery, the semiconductor element 23 is a photoelectric converting element. In the case that the semiconductor device is an image display device for a liquid crystal display, an organic EL display, a touch panel, etc., the semiconductor element 23 is an image display element. Methods for producing each of the aforementioned elements are known, and a production method suited for the type of semiconductor device may be employed.

Next, a method for producing the substrate for a semiconductor device will be described. The technique disclosed in "New Transparent Methylsilsesquioxane Aerogels and Xerogels with Improved Mechanical Properties", K. Kanamori et al., Advanced Materials, Vol. 19, Issue 12, pp. 1589-1593, 2007 may be employed to form the porous layer, for example. This method employs a surfactant as a template to form the porous layer, and is a comparatively inexpensive production method. In addition, because the solvent extraction method is employed to remove the surfactant, processing conditions are milder than those of the supercritical drying method, and therefore this method is suited for continuous production.

First, a coating liquid is prepared. At least one type of alkoxysilane selected from a group consisting of monoalkoxysilane, dialkoxysilane, and trialkoxysilane, and tetraalkoxysilane are mixed with a solvent. Water, ethanol, methanol, and the like may be employed as the solvent. In addition, a mixed solvent, in which isopropyl alcohol, methylethyl ketone or the like are mixed into water, ethanol, methanol, etc. may be utilized.

At this time, it is preferable for the mass ratio of tetraalkoxysilane with respect to all of the alkoxysilanes included in the coating liquid to be 80% or less, and more preferably within a range from 20% to 80%. In cases that the amount of tetraalkoxysilane within the solution is less than 20%, the effect of increased elastic modulus becomes difficult to obtain, although this also depends on the selection of other alkoxysilanes. This will result in great amounts of temporary shrinking during drying, and cracks become more likely to occur. On the other hand, if the amount of tetraalkoxysilane within the solution is greater than 80%, gelatinization proceeds too rapidly and there are cases in which film formation becomes difficult. This is because the stability of tetrasilanol within the coating liquid is low, polycondensation reactions proceed within comparatively short amounts of times even at low temperature, resulting in shorter pot life for the coating liquid.

Note that the coating liquid may also include other components, such as various acids (for example, chloride, acetic acid, sulfuric acid, nitric acid, phosphoric acid, etc.), various bases (for example, ammonia, sodium hydroxide, sodium hydrogen carbonate, etc.), curing agents (for example, metallic chelate, etc.), and viscosity adjusting agents (for example, polyvinyl alcohol, polyvinyl pyrolidone, etc.), in addition to precursors of matrices having inorganic substances as main components, hollow inorganic particles, and solvents.

A coating film is formed by coating the coating liquid prepared as described above onto a substrate. The method by which the coating liquid is coated onto the substrate is not particularly limited. Examples of coating methods include: the doctor blade method, the wire bar method, the gravure method, the spray method, the dip coat method, the spin coat method, the capillary coat method, etc.

The surfactant to be employed is not particularly limited. The surfactant may be cationic, anionic, or nonionic. Specific examples of suitable surfactants include: chlorides, such as alkyl trimethyl ammonium, alkyl triethyl ammonium, dialkyl dimethyl ammonium, and benzyl ammonium; bromides; iodides; hydroxides; fatty acid salts; alkyl sulfonate; alkyl phosphate; polyol series nonionic surfactants; polyethylene oxide series nonionic surfactants; and primary alkyl amines. These surfactants may be used either singly or in combinations of two or more types mixed together.

It is preferable for the concentration of the surfactant win the solution to be within a range from 0.05 mol/L to 1 mol/L. If the concentration is less than 0.05 mol/L, formation of pores tends to become incomplete. On the other hand, if the concentration is greater than 1 mol/L, the amount of surfactant that remains in the solution without reacting increases, and the uniformity of the pores tends to deteriorate.

Reaction conditions are appropriately selected according to the alkoxysilane to be used. Generally, hydrolysis/ condensation reactions are performed over 1 to 72 hours at a temperature within a range from 0 to 100°C. Thereby, a porous layer having a density of $0.7g/cm^3$ or less can be formed.

Note that here, a case in which a surfactant is added to the coating liquid for the porous layer has been described. Alternatively, in the case that the alkoxysilane is a cyclic siloxane monomer, a porous layer having a density of $0.7g/cm^3$ or less can be produced by a sol gel method using the cyclic siloxane monomer as a raw material.

Hereinafter, the method for producing the substrate for a semiconductor element of the second invention will be described in greater detail with embodiments.

[Embodiments of the Second Invention]

(Embodiment 1)

[Adhesion Layer Forming Step]

10 parts of 3-glycidoxypropyltrimethoxysilane, 10 parts of phenyltriethoxysilane, 0.2 parts of aluminum acetylacetonate, 2 parts of hydrochloric acid, and 5 parts of water were mixed to produce a coating liquid A for an adhesion layer.
UV ozone processes were administered for five minutes on a PEN film having a thickness of 100μm and a maximum protrusion size of 0.01μm. A coating film was formed on the processed PEN film by coating the coating liquid A by the doctor blade method. The coating film was dried at 100°C and the solvent was removed. Next, the coating film was heated for one hour at 170°C, and cured by a condensation reaction to become an adhesion layer.

[Porous Layer Forming Step]

35 parts of a 0.01M acetic acid solution, 13 parts of tetramethoxysilane, 12 parts of methyltrimethoxysilane, 5.5 parts of Pluronic F-127 (a polyol series nonionic surfactant), and 2 parts urea were mixed to produce a coating liquid B for a porous layer. A coating film was formed on the PEN film having the adhesion layer formed thereon, by coating the coating liquid B using the doctor blade method. The formed coating film was placed in a hermetically sealed container, and caused to hydrolyze for three days at 60°C. Then, the film was cleansed in water at a temperature of 60°C. Next, solvent substitution was sequentially performed within methanol at 60°C and within a fluorine solvent (Novec-7100 by Sumitomo 3M) at 55°C. Finally, the film was dried, to obtain a substrate for a semiconductor element in which an adhesion layer and a porous layer are formed on a PEN film substrate.

(Embodiment 2)

A substrate for a semiconductor element was obtained in the same manner as Embodiment 1, except that a glass substrate was used instead of the PEN film, and that the coating liquid A was coated on the glass substrate by the spin coat method.

(Embodiment 3)

A substrate for a semiconductor element was obtained in the same manner as Embodiment 1, except that 35 parts of a 0.01M acetic acid solution, 16 parts of tetramethoxysilane, 10 parts of methyltrimethoxysilane, 5.5 parts of Pluronic F-127 (a polyol series nonionic surfactant), and 2.5 parts urea were mixed to produce a coating liquid C for a porous layer.

(Embodiment 4)

A substrate for a semiconductor element was obtained in the same manner as Embodiment 1, except that 35 parts of a 0.01M acetic acid solution, 13 parts of tetramethoxysilane, 11 parts of methyltrimethoxysilane, 2 parts of phenyltrimethoxysilane, 5.5 parts of Pluronic F-127 (a polyol series nonionic surfactant), and 2.5 parts urea were mixed to produce a coating liquid D for a porous layer.

(Comparative Example 1)

A substrate for a semiconductor element was obtained in the same manner as Embodiment 1, except that 35 parts of a 0.01M acetic acid solution, 24 parts of methyltrimethoxysilane, 5.5 parts of Pluronic F-127 (a polyol series nonionic surfactant), and 2.5 parts urea were mixed to produce a coating liquid E for a porous layer.

(Comparative Example 2)

A substrate for a semiconductor element was obtained in the same manner as Embodiment 1, except that 35 parts of a 0.01M acetic acid solution, 21 parts of tetramethoxysilane, 5 parts of methyltrimethoxysilane, 5.5 parts of Pluronic F-127 (a polyol series nonionic surfactant), and 2.5 parts urea were mixed to produce a coating liquid F for a porous layer.

(Density of Porous Layer)

The coating liquids B through F that formed the porous layers were placed in a semi hermetically sealed Teflon™ container, and gelatinization reactions were performed for two days at 80°C. The surfactant was cleansed and removed from the wet gel in boiling water, and solvent substitution was performed with a methanol and fluorine solvent (Novec-7100 by Sumitomo 3M). The gel was dried to obtain a transparent dry gel. The pore volumes of the porous layers obtained by BET measurement, and the densities of the porous layers were calculated by Formula (3) described above using the pore volumes are shown in Table 3. Calculations were performed assuming that the true density of polymethyl silsesqui-oxane was 1.3g/cm$^3$.

(Observation of Cracks)

The numbers of cracks within 5cm squares of the porous layers of the Embodiments and the Comparative Examples were observed by an optical microscope.

(Upper Temperature Limits of Porous Layers)

The porous layers were separated from the substrates for semiconductor elements produced in the Embodiments and the Comparative Examples, and the upper temperature limits thereof were measured by thermogravimetric analysis.

The compositional ratios, the pore volumes, the densities, and the above measurement results are shown in Table 3.

TABLE 3

|  | Substrate | Mass Ratio of Tetraalkoxysilane | Pore Diameter (nm) | Pore Volume (cm$^3$/g) | Density (g/cm$^3$) | Cracks | Upper Temperature Limit (°C) |
|---|---|---|---|---|---|---|---|
| E1 | PEN | 52% (13/25) | 32 | 1.6 | 0.42 | None | 490 |
| E2 | Glass | 52% (13/25) | 32 | 1.6 | 0.42 | None | 490 |
| E3 | PEN | 62% (16/26) | 25 | 1.7 | 0.40 | None | 500 |
| E4 | PEN | 50% (13/26) | 28 | 1.5 | 0.44 | None | 520 |
| CP1 | PEN | 0% (0/24) | 30 | 1.6 | 0.42 | Many | 420 |
| CF2 | PEN | 81% (21/26) | N/A | N/A | N/A | N/A | N/A |

As is clear from Table 3, cracks did not occur in any of the substrates for semiconductor elements of Embodiments 1 through 4. The porous layer of Comparative Example 1 was formed by a coating liquid that did not include any tetraalkoxysilane. In this case, because the percentage of siloxane bonds within the porous layer is small, the amount of temporary shrinkage during drying of the porous layer cannot be decreased, and a great number of cracks were present in the porous layer. Meanwhile, the amount of tetraalkoxysilane in the coating liquid of Comparative Example 2 was great, at 81%. Therefore, gelatinization proceeded too rapidly, and a film could not be formed.

In addition, the substrates for semiconductor elements of Embodiments 1 through 4 have high upper temperature limits within the range from 490°C to 520°C. Therefore, when semiconductor elements are provided on the substrates for semiconductor elements, it is possible to apply a sufficient amount of heat necessary to improve the performance of the semiconductor elements before the heat begins to influence the substrate. Accordingly, high performance semiconductor devices can be produced at low cost, without complex steps, and with favorable productivity.

Hereinafter, a substrate for a semiconductor element according to the third invention will be described with reference to the attached drawings. Figure 6 is a schematic sectional view that illustrates a substrate 31 for a semiconductor element according to an embodiment of the third invention. As illustrated in Figure 6, the substrate 31 for a semiconductor element of the third invention is of a configuration in which an adhesion layer 33 formed by a compound obtained by hydrolyzing and condensing an alkoxysilane is provided on a substrate 32, and a porous layer 34 having a density of 0.7g/cm$^3$ or less, formed by a compound obtained by hydrolyzing and condensing an alkoxysilane, is provided on the adhesion layer 33.

It is preferable for the density of the porous layer 34 to be 0.7g/cm$^3$ or less, and more preferably to be within a range from 0.1g/cm$^3$ to 0.7g/cm$^3$. If the density of the porous layer becomes greater than 0.7g/cm$^3$, the heat transfer

rate will increase, and the substrate may be affected by heating of the semiconductor element layer during annealing or the like, depending on the material thereof. Meanwhile, if the density of the porous layer is less than $0.1g/cm^3$, the adhesion properties with respect to the substrate will deteriorate depending on the material thereof. In addition, it will become difficult for the porous layer to have structural strength suited for a semiconductor device.

The density of the porous layer may be obtained by the nitrogen adsorption measurement method (BET), for example. The nitrogen adsorption measurement method is capable of measuring pore diameters and pore volumes V $[cm^3/g]$. If $\rho[g/cm^3]$ is designated as the true density of the porous layer, from which the pores have been removed, the porosity and density of the porous layer (polysilsesquioxane) of the third invention can be calculated from the following Formula (3) .

$$\text{Density:} \quad \rho/(\rho V+1)\,[g/cm^3] \quad\quad\quad (3)$$

Note that the true density of polymethyl silsesquioxane is known to be approximately $1.3g/cm^3$ to $1.4g/cm^3$ ("New Transparent Methylsilsesquioxane Aerogels and Xerogels with Improved Mechanical Properties", K. Kanamori et al., Advanced Materials, Vol. 19, Issue 12, pp. 1589-1593, 2007).

If the apertures that function as pores are too large, problems may occur with respect to the smoothness of the surface of the film. Therefore, it is preferable for the pore diameters to be 100nm or less. On the other had, if the pore diameters are too small, the density of the silicone resin layer will decrease, and it will become difficult to obtain a silicone resin layer having structural strength suited for a semiconductor device, depending on the material of the substrate. Accordingly, the preferred range of pore diameters is from 1nm to 100nm, and more preferably from 2nm to 50nm. It is possible to measure the pore diameters by the aforementioned nitrogen adsorption measurement method. Alternatively, the pore diameters may be derived by image processing administered on a transmission electron microscope image.

Note that nitrogen molecules cannot be adsorbed onto blocked pores and pores having diameters of several nm or less. Therefore, it is not possible to measure such pores by the aforementioned nitrogen adsorption measurement method. However, the porous silicone resin layer of the first invention is constituted substantially entirely by open pores having diameters of several 10's of nanometers or greater, and there are no practical problems in obtaining the density thereof by the nitrogen adsorption measurement method. Note that the density and pore volume may alternatively be measured by the Archimedes method, by a pycnometer, by X ray reflectivity measurement, by an ellipsometer, by dielectric measurement, by position age measurement, etc.

The thickness of the silicone resin layer differs depending on the density and the heat transfer rate of the porous structure, necessary annealing temperatures, and employed heating methods. However, a thickness of 1μm or greater will enable the silicone resin layer to function sufficiently as a heat insulating layer which is not influenced by heating of the semiconductor element layer during annealing or the like.

A tetraalkoxysilane having four alkoxy groups, a trialkoxysilane having three alkoxy groups, a dialkoxysilane having two alkoxy groups, or a monoalkoxysilane having one alkoxy group may be employed as the alkoxysilane (a monomer which is a starting material) employed in the adhesion layer and the porous layer A. The types of the alkoxy groups are not particularly limited. However, alkoxy groups having comparatively small numbers of carbon atoms (carbon numbers from 1 to 4), such as methoxy groups, ethoxy groups, propoxy groups, and butoxy groups are advantageous from the viewpoint of reactive properties. In the case that trialkoxysilane or dialkoxysilane is employed, organic groups, hydroxyl groups, and the like may be bonded to the silicon atoms within the alkoxysilane. The organic groups may further have functional groups, such as epoxy groups, amino groups, mercapto groups, and vinyl groups.

Preferred examples of the tetraalkoxysilanes include: tetramethoxysilane; tetraethoxysilane; tetraisopropoxysilane; and dimethoxydiethoxysilane.

Preferred examples of trialkoxysilanes include: methyltrimethoxysilane; propyltrimethoxysilane; hexyltrimethoxysilane; octadecyltrimethoxysilane; phenyltrimethoxysilane; aryltrimethoxysilane; vinyltrimethoxysilane; cyanopropyltrimethoxysilane; 3-bromopropyltrimethoxysilane; 3-chloropropyltrimethoxysilane; 2-(3, 4-epoxycyclohexyl) ethyltrimethoxysilane; 3-glycidyloxypropyltrimethoxysilane; 3-iodopropyltrimethoxysilane; 3-mercaptopropyltrimethoxysilane; trimethoxy [2-(7-oxabicyclo [4, 1, 0] hepto-3-yl) ethyl] silane; 1-[3-(trimethoxysilyl) propyl] urea; N-[3-(trimethoxysilyl) propyl] anylene; trimethoxy [3-phenylaminopropyl] silane; acryloxypropyltrimethoxysilane; methacryloxypropyltrimethoxysilane; trimethoxy [2-phenylethyl] silane; trimethoxy (7-octen-1-yl) silane; trimethoxy (3,3,3-trifluoropropyl) silane; 3-[2-(2-aminoethylamino) ethylamino] propyltrimethoxysilane; [3-(2-aminothylamino) propyl] trimethoxysilane; 3-glysidoxypropyltrimethoxysilane; 3-aminopropyltrimethoxysilane; 3-diethylaminopropyltrimethoxysilane; bis (3-methylamino) propyltrimethoxysilane; N,N-dimethylaminopropyltrimethoxysilane; N-[3-(trimethoxylsilyl) propyl] ethylenediamine; trimethoxy (3-methylamino) propylsilane; methyltrimethoxysilane; propyltriethoxysilane; octadecyltriethoxysilane; phenyltriethoxysilane; aryltriethoxysilane; (1-naphtyl) triethoxysilane; [2-(cyclohexynyl) ethyl] triethoxysilane; 3-aminopropyltriethoxysilane; 3-[bis(2-hydroxyethyl) amino] propyltriethoxysilane; 3-chloropropyltriethoxysilane; 3-glycidyloxypropyltriethoxysilane; 3-mercaptopropyltriethoxysilane; 4-chlorophenyltriethoxysilane; (bicyclo [2,2,1] hepto-5-en-2-yl) triethoxysilanel; chloromethyltriethoxysilane; pentafluorophenyltriethoxysilane; 3-(triethoxysilyl) propyonitryl; 3-(triethoxysilyl) propylisocyanate; bis [3-triethoxysilylpropyl] tetrasulfide; triethoxy (3-isocyanatopropyl) silane; and triethoxy (3-thioisocyanatopropyl) silane.

Preferred examples of dialkoxysilanes include: dimethoxydimethylsilane; dimethoxydimethylsilane; dimethoxy-3-glycidoxydipropylmethylsilane; dimethoxydiphenylsilane, and dimethoxydimethylphenylsilane.

These alkoxysilanes may be employed either singly or in combinations of two or more. In addition, the alkoxysilanes having 2 to 4 alkoxy groups may also be utilized in combination with monoalkoxysilanes having 1 alkoxy group. Examples of such monoalkoxysilanes include: trimethylmethoxysilane; trimethylethoxysilane; and 3-chloropropyldimethylmethoxysilane.

The alkoxysilane that constitutes the adhesion layer and the alkoxysilane that constitutes the porous layer may be the same alkoxysilane, or different alkoxysilanes. It is preferable for the alkoxysilane to be employed in the adhesion layer to be selected from among monoalkoxysilane, dialkoxysilane, and trialkoxysilane, because they have functional groups that interact with the resin substrate, and from the viewpoint of forming siloxane bonds with the porous layer. It is preferable for a trialkoxysilane having three alkoxy groups, particularly organoalkoxysilane, to be selected as the alkoxysilane for the adhesion layer.

The organoalkoxysilane is represented by chemical formula $Si (R^1)_m (OR^2)_{4-m}$. m is an integer from 1 to 3, and $R^1$ and $R^2$ are organic groups having a carbon number of 1 or greater. It is preferable for $R^1$ to have a carbon number from 1 to 8, and to be an organic group that may include other elements, such as N, O, and S. It is preferable for $R^2$ to be an organic group that has a carbon number from 1 to 8. Examples of organic groups ($-R^1$) include: $-CH_3$; $-C_2H_5$; $-C_3H_7$; $-C_4H_9$; $-CHOCH-$; $-CH=CH_2$: $-C_6H_5$; $-CF_3$; $-C_2F_5$: $-C_3F_7$; $-C_4F_9$; $-CH_2CH_2CF_3$; $-CH_2CH_2C_6F_{13}$; $-CH_2CH_2C_8F_{17}$; $-C_3H_6NH_2$; $-C_3H_6NHC_2H_4NH_2$; $-C_3H_6OCH_2CHOCH_2$; and $-C_3H_6OCOC (CH_3) =CH_2$. Epoxy groups, amino groups, mercapto groups, and vinyl groups are particularly preferred.

It is preferable for the alkoxy group ($OR^2$) to be a methoxy group, an ethoxy group, a propoxy group, a butoxy group, or the like. An alkoxy group having a comparatively small number of carbon atoms (carbon numbers from 1 to 4) is advantageous from the viewpoint of reactive properties. Note that in the case that a plurality of the organic groups and the alkoxy groups are respectively present within the same molecules, different groups may be employed.

It is desirable for the alkoxysilane to be used for the porous layer to be selected from among tetramethoxysilane, methyltrimethoxysilane, and dimethylmethoxysilane. These alkoxysilanes may be employed singly or in combinations.

Examples of resin materials for a resin substrate include: triacetyl cellulose (TAC); polyethylene terephthalate (PET); polyethylene naphthalate (PEN); syndiotactic polystyrene (SPS); polyphenylene sulfide (PPS); polycarbonate (PC); polyarylate (PAr); polysulfone (PSF); polyester sulfone (PES); polyetherimide (PEI); cyclic polyolefin; and polyimide (PI).

Processes may be administered to the surface of the resin substrate, in order to further improve the adhesive properties between the adhesion layer and the resin substrate. Examples of such surface processes include: surface grafting; and processes performed with oxygen plasma, argon plasma, ultraviolet ray irradiation, electron beam irradiation, a flaming process, and an ozone process.

The substrate for a semiconductor element of the third invention is of a configuration in which the adhesion layer formed by a compound obtained by hydrolyzing and condensing an alkoxysilane is provided on the substrate, and the porous layer having a density of $0.7 g/cm^3$ or less, formed by a compound obtained by hydrolyzing and condensing an alkoxysilane, is provided on the adhesion layer. From a microscopic viewpoint, it is estimated that intermolecular forces are primarily applied between the substrate and the adhesion layer, while chemical bonds (siloxane bonds) are primarily formed between the adhesion layer and the porous layer, to secure adhesion. In addition, because the organic functional groups of alkoxysilane are introduced, the substrate for a semiconductor element of the third invention has a characteristic feature that it has a lower modulus of elasticity compared against materials formed solely by inorganic bonds, such as silica materials. For this reason, the substrate for a semiconductor element of the third invention has high resistance against bending, and uses that utilize the flexible properties of the substrate can be expected.

Next, a method for producing the substrate for a semiconductor device will be described. First, a coating liquid for the adhesion layer is prepared. The coating liquid is obtained by mixing the aforementioned alkoxysilane and a solvent. Water, ethanol, methanol, and the like may be employed as the solvent. In addition, a mixed solvent, in which isopropyl alcohol, methylethyl ketone or the like are mixed into water, ethanol, methanol, etc. may be utilized.

Note that the coating liquid may also include other components, such as various acids (for example, chloride, acetic acid, sulfuric acid, nitric acid, phosphoric acid, etc.), various bases (for example, ammonia, sodium hydroxide, sodium hydrogen carbonate, etc.), curing agents (for example, metallic chelate, etc.), and viscosity adjusting agents (for example, polyvinyl alcohol, polyvinyl pyrolidone, etc.), in addition to precursors of matrices having inorganic substances as main components, hollow inorganic particles, and solvents.

A first coating film is formed by coating the coating liquid prepared as described above on a resin substrate. The method by which the coating liquid is coated onto the substrate is not particularly limited. Examples of coating methods include: the doctor blade method, the wire bar method, the gravure method, the spray method, the dip coat method, the spin coat method, the capillary coat method, etc.

Next, heating that causes the alkoxysilane within the first coating film to be hydrolyzed and condensed is performed. Alkoxysilanes gradually condense into high molecular weights as hydrolysis/condensation reactions of the alkoxysilane process by the sol gel reaction. It is preferable for the heating temperature to be within a range from 50°C to 200°C, and for the reaction time to be within a range from 5 minutes to 1 hour. If the heating temperature exceeds 200°C, pores will be formed in the condensed alkoxysilanes. It is preferable for the thickness of the formed adhesion layer to be 10μm or less, more preferably 2μm or less, and even more preferably 1μm or less.

Next, a coating liquid for the porous layer is prepared. The technique disclosed in "New Transparent Methylsilsesquioxane Aerogels and Xerogels with Improved Mechanical Properties", K. Kanamori et al., AdvancedMaterials, Vol. 19, Issue 12, pp. 1589-1593, 2007 may be employed to form the porous layer, for example. This method employs a surfactant as a template to form the porous layer, and is a comparatively inexpensive production method. In addition, because the solvent extraction method is employed to remove the surfactant, processing conditions are milder than those of the supercritical drying method, and therefore this method is suited for continuous production.

The surfactant to be employed is not particularly limited. The surfactant may be cationic, anionic, or nonionic. Specific examples of suitable surfactants include: chlorides, such as alkyl trimethyl ammonium, alkyl triethyl ammonium, dialkyl dimethyl ammonium, and benzyl ammonium; bromides; iodides; hydroxides; fatty acid salts; alkyl sulfonate; alkyl phosphate; polyol series nonionic surfactants; polyethylene oxide series nonionic surfactants; and primary alkyl amines. These surfactants may be used either singly or in combinations of two or more types mixed together.

It is preferable for the concentration of the surfactant win the solution to be within a range from 0.05 mol/L to 1 mol/L. If the concentration is less than 0.05 mol/L, formation of pores tends to become incomplete. On the other hand, if the concentration is greater than 1 mol/L, the amount of surfactant that remains in the solution without reacting increases, and the uniformity of the pores tends to deteriorate.

Reaction conditions are appropriately selected according to the alkoxysilane to be used. Generally, hydrolysis/condensation reactions are performed over 1 to 72 hours at a temperature within a range from 0 to 100°C. Thereby, a porous layer having a density of $0.7g/cm^3$ or less can be formed.

Note that here, a case in which a surfactant is added to the coating liquid for the porous layer has been described. Alternatively, in the case that the alkoxysilane is a cyclic siloxane monomer, a porous layer having a density of $0.7g/cm^3$ or less can be produced by a sol gel method using the cyclic siloxane monomer as a raw material.

Figure 7 is a schematic sectional view that illustrates a semiconductor device that employs the substrate for a semiconductor element of the third invention. As illustrated in Figure 7, the substrate for a semiconductor element of the third invention may be employed as a substrate for a semiconductor device in which a semiconductor element 35 is provided on the substrate 31 for a semiconductor element. Note that the detailed configuration of the semiconductor element 35 differs according to the semiconductor device in which it is used, and in actuality is a complex structure. Figure 7 merely illustrates the relationship between the substrate for a semiconductor element of the third invention and the semiconductor element. However, in the case that the semiconductor device is a thin film transistor circuit, the semiconductor element 35 is a pixel switching element. In the case that the semiconductor device is a solar battery, the semiconductor element 35 is a photoelectric converting element. In the case that the semiconductor device is an image display device for a liquid crystal display, an organic EL display, a touch panel, etc., the semiconductor element 35 is an image display element. Methods for producing each of the aforementioned elements are known, and a production method suited for the type of semiconductor device may be employed.

Hereinafter, the method for producing the substrate for a semiconductor element of the third invention will be described in greater detail with embodiments.

[Embodiments of the Third Invention]

(Embodiment 1)

[Adhesion Layer Forming Step]

10 parts of 3-glycidoxypropyltrimethoxysilane, 10 parts of phenyltriethoxysilane, 0.2 parts of aluminum acetylacetonate, 2 parts of hydrochloric acid, and 5 parts of water were mixed to produce a coating liquid A for an adhesion layer.

UV ozone processes were administered for five minutes on a PEN film having a thickness of 100μm and a maximum protrusion size of 0.01μm. A coating film was formed on the processed PEN film by coating the coating liquid A by the doctor blade method. The coating film was dried at 100°C and the solvent was removed. Next, the coating film was heated for one hour at 170°C, and cured by a condensation reaction to become an adhesion layer.

[Porous Layer Forming Step]

13 parts of a 0.01M acetic acid solution, 9 parts of methyltrimethoxysilane, 2 parts of Pluronic F-127 (a polyol series nonionic surfactant), and 1 part urea were mixed to produce a coating liquid B for a porous layer. A coating film was formed on the PEN film having the adhesion layer formed thereon, by coating the coating liquid B using the doctor blade method. The formed coating film was placed in a hermetically sealed container, and caused to hydrolyze for three days at 60°C. Then, the film was cleansed in water at a temperature of 60°C. Next, solvent substitution was sequentially performed within methanol at 60°C and within a fluorine solvent (Novec-7100 by Sumitomo 3M) at 55°C. Finally, the film was dried, to obtain a substrate for a semiconductor element in which an adhesion layer and a porous layer are formed on a polymer substrate. The thickness of the porous layer was 6μm.

(Embodiment 2)

A substrate for a semiconductor element was obtained in the same manner as Embodiment 1, except that 5 parts of methyltrimethoxysilane, 2.8 parts of aminopropyltriethoxysilane, 0.2 parts of aluminum acetylacetonate, 2 parts of hydrochloric acid and 5 parts water were mixed to produce a coating liquid C for an adhesion layer, which was used instead of the coating liquid A.

(Comparative Example 1)

A substrate for a semiconductor element was obtained in the same manner as Embodiment 1, except that the step of forming the adhesion layer was omitted.

(Comparative Example 2)

73 parts of isopropyl alcohol, 15 parts of aluminum-tri-sec-butoxide, 8 parts diacetic ether and 4 parts water were mixed to produce a coating liquid D for an intermediate layer. UV ozone processes were administered for five minutes on a PEN film. A coating film was formed on the processed PEN film by coating the coating liquid D by the doctor blade method. The coating film was dried at room temperature. Next, the coating film was processed for 20 minutes in water at 60°, and heated at 60° to become an intermediate layer. The coating liquid B of Embodiment 1 was coated on the formed intermediate layer by the doctor blade method, to form a coating film, then the same processes as those in the porous layer forming step of Embodiment 1 were performed, to obtain a substrate for a semiconductor element.

(Density of Porous Layer)

The coating liquid B that formed the porous layers were placed in a semi hermetically sealed Teflon™ container, and gelatinization reactions were performed for two days at 80°C. The surfactant was cleansed and removed from the wet gel in boiling water, and solvent substitution was performed with a methanol and fluorine solvent (Novec-7100 by Sumitomo 3M). The gel was dried to obtain a transparent dry gel. The pore volumes of the porous layers obtained by BET measurement, and the densities of the porous layers were calculated by Formula (3) described above using the pore volumes are shown in Table 3. Calculations were performed assuming that the true density of polymethyl silsesquioxane was $1.3 g/cm^3$ ("New Transparent Methylsilsesquioxane Aerogels and Xerogels with Improved Mechanical Properties", K. Kanamori et al., Advanced Materials, Vol. 19, Issue 12, pp. 1589-1593, 2007). Note that the density obtained by the Archimedes method was $0.40 g/cm^3$.

(Observation of Separation)

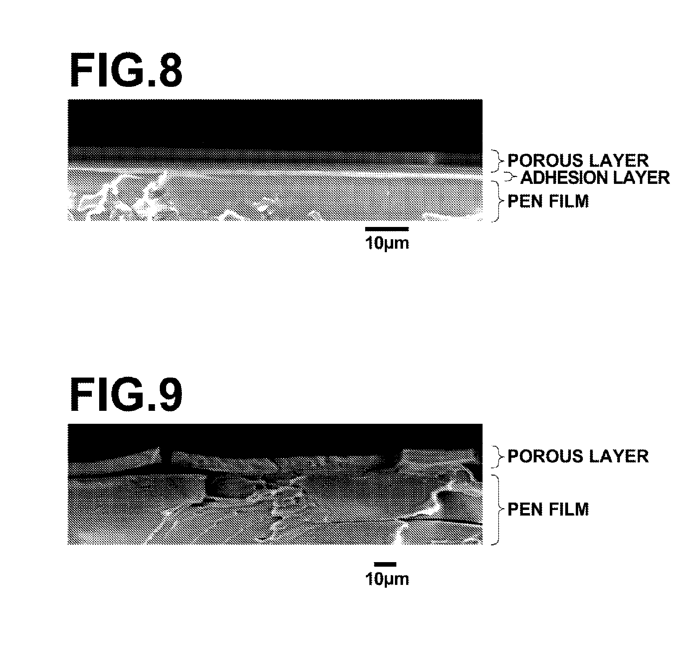

Whether the porous layers had separated from the substrates for semiconductor layers of the Embodiments and the Comparative Examples was visually confirmed. The results are shown in Table 4, along with the components of the adhesion layer (the intermediate layer in Comparative Example 2) . In addition, sectional SEM images of Embodiment 1 and Comparative Example 1 are illustrated in Figure 8 and Figure 9.

TABLE 4

|  | Components of Adhesion Layer (Intermediate Layer) | Separation |
|---|---|---|
| Embodiment 1 | 3-glycidoxypropyltrimethoxysilane phenyltriethoxysilane | NO |

(continued)

|  | Components of Adhesion Layer (Intermediate Layer) | Separation |
|---|---|---|
| Embodiment 2 | methyltrimethoxysilane aminopropyltriethoxysilane | No |
| Comparative Example 1 | No adhesion layer | Yes |
| Comparative Example 2 | Aluminum-tri-sec-butoxide | Yes |

As is clear from Table 4 and the sectional SEM images of the substrates for semiconductors of Figure 8 and Figure 9, the porous silicone compound layer formed on the PEN film by coating began separating therefrom while undergoing hydrolysis by the sol gel reaction in Comparative Example 1, which did not have an adhesion layer. In contrast, the adhesion layer prevents the porous layer from becoming separated throughout the hydrolysis and surfactant solvent removal, and it can be seen that the porous layer is formed on the PEN film in Embodiment 1, which is provided with the adhesion layer. Note that Comparative Example 2 was provided with a compound obtained by hydrolyzing and condensing aluminum-tri-sec-butoxide as an intermediate layer. In this case, the adhesive properties between the PEN film and the intermediate layer were comparatively favorable. However, the adhesive properties between the intermediate layer and the porous silicon compound layer was insufficient, resulting in separation of the porous layer from the substrate.

In addition, in dense coatings of metal oxides formed by hydrolysis of metal alkoxides represented by silane compounds by the conventional sol gel method, gel films contract by the hydrolysis reaction, and tears and separation occur by stress generated when densification is attempted. Therefore, the maximum thickness (referred to as thickness limit) of films that can be formed in a single coating operation had been limited to approximately 100nm (approximately $1\mu m$ for silica films, S. Sakka, Application of Sol-Gel Processing to Nanotechnology, CMC Publishing, 2005). Various measures had been taken to solve this problem. Examples of such measures include: controlling the speed of hydrolysis reactions by adding acetyl acetone as a chelating agent; and suppressing polymerization reactions by adding polyvinyl pyrolidone to form organic-inorganic hybrid structures with silica backbones (S. Sakuhana, Application of Sol-Gel Processing to Nanotechnology, CMC Publishing, 2005) . However, according to the method for producing a substrate for a semiconductor element of the third invention, these complex conventional techniques need not be employed to form thick films on the order of $6\mu m$, as exemplified by Embodiment 1.

## Claims

1. A semiconductor device (1), comprising:

    a substrate (2); and
    a semiconductor element (3); **characterized by**:

        a porous structure layer (4) formed by silicone resin being provided between the substrate and the semiconductor layer.

2. A semiconductor device (1) as defined in Claim 1, **characterized by**:

    the density of the porous structure layer (4) formed by silicone resin being $0.7g/cm^3$ or less.

3. A semiconductor device (1) as defined in Claim 2, **characterized by**:

    95% by mass or greater of the porous structure layer (4) formed by silicone resin being a silicone resin constituted by silsesquioxane or siloxane, and 20% by mass or greater of the silicone resin being silsesquioxane.

4. A semiconductor device (1) as defined in Claim 3, **characterized by**:

    the silsesquioxane being methyl silsesquioxane or phenyl silsesquioxane.

5. A semiconductor device (1) as defined in any one of Claims 1 through 4, **characterized by**:

    the substrate (2) being a resin substrate.

**6.** Amethod for producing a semiconductor device (1) as defined in any one of Claims 1 through 5, **characterized by** comprising:

providing the porous structure layer (4) formed by silicone resin on the substrate (2);
providing a semiconductor element layer (3) on the porous structure layer (4); and
intermittently heating the device only from the side of the semiconductor element layer (3).

**7.** Amethod for producing a semiconductor device (1) as defined in Claim 6, **characterized by**:

the heating being performed by light or by an electron beam.

**8.** A semiconductor device (21), comprising:

a substrate (22); and
a semiconductor element (23); **characterized by**:

a porous layer (24) having a density of $0.7g/cm^3$ or less formed by a compound obtained by hydrolyzing and condensing at least one type of alkoxysilane selected from a group consisting of monoalkoxysilane, dialkoxysilane, and trialkoxysilane, and tetraalkoxysilane, being provided between the substrate (22) and the semiconductor layer (23).

**9.** A semiconductor device (21) as defined in Claim 8, **characterized by**:

the at least one type of alkoxysilane being a trialkoxysilane.

**10.** A semiconductor device (21) as defined in Claim 9, **characterized by**:

the trialkoxysilane being methyl trialkoxysilane.

**11.** A method for producing a substrate for a semiconductor element, **characterized by** comprising:

coating a substrate (22) with a coating solution containing at least one type of alkoxysilane selected from a group consisting of monoalkoxysilane, dialkoxysilane, and trialkoxysilane, and tetraalkoxysilane, to form a coating film; and
forming a porous layer (24) having a density of $0.7g/cm^3$ or less by heating that causes hydrolysis and condensation of the alkoxysilanes within the coating film.

**12.** A method for producing a substrate for a semiconductor element as defined in Claim 11, **characterized by**:

the percentage by mass of tetraalkoxysilane with respect to all of the alkoxysilanes included in the coating solution being 80% or less.

**13.** A method for producing a substrate for a semiconductor element as defined in either one of Claim 11 or Claim 12, **characterized by**;
the coating solution containing a surfactant; and
the surfactant being removed after heating the alkoxysilanes within the coating film to cause the hydrolysis and the condensation reaction.

**14.** A substrate (31) for a semiconductor element, **characterized by** comprising:

a resin substrate (32);
an adhesion layer (33) formed by a compound obtained by hydrolyzing and condensing an alkoxysilane provided on the substrate (32); and
a porous layer (34) having a density of $0.7g/cm^3$ or less, formed by a compound obtained by hydrolyzing and condensing an alkoxysilane, provided on the adhesion layer (33).

**15.** A substrate (31) for a semiconductor element as defined in Claim 14, **characterized by**:

the alkoxysilane which is employed to form the adhesion layer (33) being organo trialkoxysilane; and
the alkoxysilane which is employed to form the porous layer (34) being an alkoxysilane selected from a group consisting of tetramethoxysilane, methyltrimethoxysilane, and methyldimethoxysilane.

16. Amethod for producing a substrate (31) for a semiconductor element, **characterized by** comprising:

coating a resin substrate (32) with a coating solution containing an alkoxysilane, to form a first coating film;
forming an adhesion layer (33) by heating that causes hydrolysis and condensation of the alkoxysilane within the first coating film;
coating the adhesion layer (33) with a coating solution containing an alkoxysilane, to form a second coating film;
forming a porous layer (34) having a density of $0.7 g/cm^3$ or less by heating that causes hydrolysis and condensation of the alkoxysilanes within the second coating film.

17. Amethod for producing a substrate (31) for a semiconductor element as defined in Claim 16, **characterized by**;
the coating solution for forming the porous layer (34) including a surfactant; and
the surfactant being removed after heating the alkoxysilane within the second coating film to cause the hydrolysis and the condensation reaction.

18. A thin film transistor circuit, **characterized by** comprising:

a substrate (31) for semiconductor elements as defined in either one of Claim 14 or Claim 15; and
a semiconductor element (35).

19. A solar battery, **characterized by** comprising:

a substrate (31) for semiconductor elements as defined in either one of Claim 14 or Claim 15; and
a semiconductor element (35).

20. An image display device, **characterized by** comprising:

a substrate (31) for semiconductor elements as defined in either one of Claim 14 or Claim 15; and
a semiconductor element (35).

# FIG.1

# FIG.2

# FIG.3

# FIG.4

**FIG.5**

21

23
24
22

**FIG.6**

31

34
33
32

**FIG.7**

35
34
33
32
31

# FIG.8

}-POROUS LAYER
-ADHESION LAYER
}-PEN FILM

10μm

# FIG.9

}-POROUS LAYER

}-PEN FILM

10μm

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11024106 A
- JP 11031828 A
- JP 2001508937 PCT
- JP 2001118841 A
- JP 2001139321 A
- JP 2003267719 A
- US 6410149 B
- US 6410199 B
- JP 2004168615 A

**Non-patent literature cited in the description**

- **K. KANAMORI et al.** New Transparent Methyl-silsesquioxane Aerogels and Xerogels with Improved Mechanical Properties. *Advanced Materials,* 2007, vol. 19 (12), 1589-1593
- **K. KANAMORI et al.** New Transparent Methyl-silsesquioxane Aerogels and Xerogels with Improved Mechanical Properties. *AdvancedMaterials,* 2007, vol. 19 (12), 1589-1593
- **S. SAKKA.** Application of Sol-Gel Processing to Nanotechnology. CMC Publishing, 2005
- **S. SAKUHANA.** Application of Sol-Gel Processing to Nanotechnology. CMC Publishing, 2005